# EUROPÄISCHE PATENTSCHRIFT

(11) **EP 3 172 768 B1**
(45) Veröffentlichungstag und Bekanntmachung des Hinweises auf die Patenterteilung: **24.10.2018**
(21) Anmeldenummer: 15756340.4
(22) Anmeldetag: 21.07.2015
(51) Int. Cl.: H01L 31/0224, H01L 31/046, H01L 31/0747

(54) **VERFAHREN ZUR HERSTELLUNG EINES RÜCKSEITENKONTAKTSYSTEMS FÜR EINE SILIZIUM-DÜNNSCHICHT-SOLARZELLE**
METHOD FOR PRODUCING A REAR-SIDE CONTACT SYSTEM FOR A SILICON THIN-LAYER SOLAR CELL
PROCÉDÉ DE FABRICATION D'UN SYSTÈME DE CONTACT CÔTÉ ARRIÈRE POUR CELLULE SOLAIRE À COUCHE MINCE EN SILICIUM

(30) Priorität: 22.07.2014 DE 102014110262
(43) Veröffentlichungstag der Anmeldung: 31.05.2017
(73) Patentinhaber: Helmholtz-Zentrum Berlin für Materialien und Energie GmbH, 14109 Berlin (DE)
(72) Erfinder: RING, Sven, 10247 Berlin (DE); WEIZMAN, Moshe, 13187 Berlin (DE); RHEIN, Holger, 10369 Berlin (DE); SCHULTZ, Christof, 10245 Berlin (DE); FINK, Frank, 14471 Potsdam (DE); GALL, Stefan, 13597 Berlin (DE); SCHLATMANN, Rutger, 14195 Berlin (DE)
(86) Internationale Anmeldenummer: PCT/DE2015/100309
(87) Internationale Veröffentlichungsnummer: WO 2016/012007

(56) Entgegenhaltungen:
- WO-A1-2005/024927
- WO-A1-2008/102172
- WO-A2-2010/012259
- US-A1- 2006 130 891
- WEIZMAN M ET AL: "Efficiency and stability enhancement of laser-crystallized polycrystalline silicon thin-film solar cells by laser firing of the absorber contacts", SOLAR ENERGY MATERIALS AND SOLAR CELLS, Bd. 120, 14. Oktober 2013 (2013-10-14), Seiten 521-525, XP028780988, ISSN: 0927-0248, DOI: 10.1016/J.SOLMAT.2013.09.033

## Beschreibung

Die Erfindung betrifft ein Verfahren zur Herstellung eines Rückseitenkontaktsystems für eine Silizium-Dünnschicht-Solarzelle mit einem aus einer Silizium-Absorberschicht und einer Emitterschicht gebildeten pn-Übergang, aufweisend die im Anspruch 1 angegebenen Verfahrensschritte. Die dem Stand der Technik nach bekannten Verfahren zur Rückseitenkontaktierung von waferbasierten Silizium-Solarzellen basieren auf Lithographie, Maskieren und "Lift-off"-Verfahren, die jedoch aufgrund ihrer Komplexität, des Handling-Aufwandes sowie der erreichbaren geringen Bearbeitungsgeschwindigkeiten nicht für eine industrielle Umsetzung zur großflächigen Anwendung auf Dünnschicht-Solarzellen geeignet sind.
Die Nutzung von Lasern für die Herstellung von Kontaktsystemen ist dagegen für die Produktion von großflächigen Dünnschicht-Solarzellen geeignet. Verschiedene Prozessschritte wie der Materialabtrag in Form von Punkten oder Linien, Materialveränderungen oder Laserdotierung durch Feuern von Kontakten sind dem Stand der Technik nach bekannt.
So werden beispielsweise in US 5,538,564 A p-und n-Kontakte mit großem Aspektverhältnis in der aktiven Schicht einer Solarzelle mittels Dotierung durch einen Pulslaser in einer den Dotanden enthaltenden Gasathmosphäre erzeugt. Dieser Laser kann ausgewählt sein aus der Gruppe der Excimer-, Farbstoff- oder YAG-Laser.

Ein weiterer wichtiger Schritt zur Realisierung eines Rückseitenkontaktsystems für Dünnschicht-Solarzellen sind mit dem Laser hergestellte Kontaktstrukturen, worunter inbesondere Löcher in einer rückseitig aufgebrachten Isolationsschicht fallen, die für die Verbindung von Metallkontakten und aktiven Solarzellenschichten notwendig sind. In DE 690 12 517 T2 ist ein Verfahren zur Bildung von Durchgangslöchern in einer Polyimid-Unterlage beschrieben, bei dem mittels eines defokussierten Kohlendioxid-Lasers definierter Energiedichte in einer sauerstoffhaltigen Atmosphäre in einem Polyimid-Substrat Löcher erzeugt und durch anschließendes chemisches Ätzen Polyimid-Rückstände entfernt werden. In dieser Veröffentlichung wird auf andere bekannte Verfahren des Laserbohrens hingewiesen. So wendet man beim Excimer-Laser die Photozersetzung mit elektromagnetischer Energie im UV-Bereich des Spektrums an, um die chemischen Bindungen des Substrats zu brechen und das Polyimid zu zersetzen. Mittels eines Argonionen-Lasers wird eine solche elektromagnetische Energie in das Polyimid-Substrat eingetragen, die den Film beschädigt, jedoch nicht zersetzt. Danach erfolgt ein Ätzschritt mittels Plasma, um das durch die Bestrahlung beschädigte Polyimid zu entfernen. Dieser Ätzschritt erzeugt jedoch Löcher mit unterschiedlichen Durchmessern oder abweichenden Lochformen, was unerwünscht ist. Werden mittels eines Kohlendioxid-Lasers die Löcher "gebohrt", entstehen beträchtliche Mengen an Rückständen in Form von abladierten Teilchen, die wieder durch einen Ätzschritt entfernt werden müssten.

Bei dem in DE 100 05 330 A1 beschriebenen Verfahren zur Herstellung von hochaufgelösten transparenten und leitfähigen Strukturen wirkt Laserstrahlung auf ausgewählte Bereiche einer nicht transparenten und nicht leitfähigen Schicht ein, wodurch das Material in den bestrahlten Bereichen in transparentes und leitfähiges Material umgewandelt wird. Sobald die Umwandlung in ein transparentes Material erfolgt ist, kann die Laserstrahlung auch in tieferliegende Schichtbereiche einwirken. Nach Einwirkung der Laserstrahlung liegen transparente und leitfähige Bereiche sowie nicht transparente und isolierende Bereiche vor, die ein unterschiedliches Ätzverhalten aufweisen, also unterschiedlich stark angegriffen werden, wodurch eine Strukturierung erfolgt.

Bei dem in DE 10 2007 051 725 A1 beschriebenen Verfahren zur Kontaktierung von Solarzellen wird eine Maskierungsschicht zur Ausbildung von schmalen Strukturen mittels Laserstrahlung geöffnet. Wird dabei die Substratoberfläche beschädigt, erhöht sich dort die Rekombination erzeugter Ladungsträger. Um derartige Schäden zu entfernen, wird die Oberfläche nasschemisch oder im Plasma geätzt.

In DE 199 15 666 A1 ist ein Verfahren zur selektiven Kontaktierung von Solarzellen, insbesondere zur Kontaktierung der Emitter- und/oder Basisschicht der Solarzelle, beschrieben. Dabei wird ein Laserstrahl auf ein Array optischer Mikrolinsen gerichtet, deren Fokuspunkte im Bereich einer dielektrischen Schicht liegen, die die elektrisch zu kontaktierende Oberfläche der Solarzelle bedeckt. An den Fokuspunkten wird durch die Belichtung Material abgetragen, bis die elektrisch zu kontaktierende Oberfläche dort freigelegt wurde. Anschließend erfolgt eine Metallisierung der freigelegten Oberfläche durch die dielektrische Schicht hindurch.

Auch in DE 10 2009 057 881 A1 werden mittels Laserstrahlung Strukturen erzeugt. Hierbei ist eine Laserstrahlung absorbierende Absorberschicht auf eine für Laserstrahlung transparente Schicht aufgebracht. Mittels Laserstrahlung werden lokal Bereiche in der Absorberschicht entfernt, anschließend werden die nun frei liegenden Bereiche der transparenten Schicht mittels eines Ätzschritts entfernt.

In WO 03/019674 A1 ist im Zusammenhang mit einer seriellen Verschaltung der Solarzellen in einem Modul auf der gesamten Oberfläche eines Solarzellen-Moduls das direkte Erzeugen von Kontaktlöchern durch eine Schicht oder mehrere Schichten bis in die Emitterschicht bzw. Absorberschicht mittels Laserbohrens beschrieben. Eine Schicht ist dabei eine isolierende Schicht, die aus zwei Teilschichten gebildet ist, wobei wiederum eine Teilschicht eine Kunstharzschicht ist.

Aus WO 2010/012259 A2 ist die Herstellung einer Heterokontakt-Silizium-Dünnschicht-Solarzelle bekannt, bei der die Kontakte für Emitter und Absorber in unterschiedliche Tiefen reichen und in Löchern mit seitlicher Isolation verlaufen, sowie die Kontakte aus TCO-Schichten bestehen können.

Von M. Weizmann et al. (Efficiency and stability enhancement of lasercrvstallized polycrystalline silicon thin-film solar cells by laser firing of the absorber contacts, Solar Energy Materials and Solar Cells, Bd. 120, 2013, S. 521 -525) ist ein Verfahren offenbart, in dem das Feuern mittels Laser (laser firinq) an polvkristallinen Silizium-Dünnschicht-Solarzellen angewendet wird an den Rückkontakten der Solarzelle, um diese zu stabilisieren. Das Feuern mittels Laser erfolgt dabei mit zigfachen Pulsen unterhalb der Ablationsschwelle, wodurch eine feinkörnige Silizium-Aluminium-Legierung entsteht, die eine, im Vergleich, erhöhte Stabilität bewirkt.

Ein Verfahren zur Herstellung eines Rückseitenkontakts für polykristalline Dünnschicht-Solarzellen wurde von M. Green et al. in Solar Energy 77, 2004, S. 857-863 beschrieben. Dabei werden auf einer isolierenden Kunstharzschicht in einem Zweistufen-Prozess mittels Inkjet-Druckprozess jeweils nacheinander die Orte mit einer Ätzlösung beaufschlagt, an denen die Kontaktlöcher bis zur Absorberschicht bzw. bis zur Emitterschicht durch Ätzen erzeugt werden sollen. In US 7,585,781 B2 ist dieses Verfahren detailliert ausgeführt, insbesondere ist die Isolierung der freiliegenden Kanten der Emitterschicht durch einen "Reflow"-Prozess des Materials der Isolationsschicht beschrieben. Von diesem Stand der Technik geht die Erfindung aus. Ergänzend sei auf die dem US-Patent zugrundeliegende WO-Anmeldung mit der Veröffentlichungsnummer WO 2005/024927 A1 verwiesen, in der eine organische Isolierschicht u.a. auch mittels Laserablation entfernt wird, bevor Löcher bis in die Silizium-Absorberschicht geätzt werden. Ebenso ist daraus die Verwendung von fotografischen Techniken bekannt, bei denen aber kein Laser eingesetzt wird.

Aufgabe der Erfindung ist es nun, ein weiteres Verfahren zur Herstellung eines Rückseitenkontaktsystems für eine Silizium-Dünnschicht-Solarzelle anzugeben, das eine große Positioniergenauigkeit und Zuverlässigkeit gewährleistet, skalierbar ist sowie eine Schädigung der Emitterschicht vermeidet. Das Verfahren soll sich gut in einen einheitlichen Herstellungsprozess für Dünnschicht-Solarzellen einpassen.

Die Aufgabe wird durch ein Verfahren der eingangs genannten Art gemäß Anspruch 1 gelöst. Ausführungsformen der Erfindung sind den Unteransprüchen zu entnehmen.

Erfindungsgemäß wird vor dem Aufbringen der organischen Isolationsschicht auf die Emitterschicht eine TCO-Schicht aufgebracht. Löcher für die Kontakte zur Silizium-Absorberschicht in der Isolationsschicht werden erzeugt, indem zunächst an zukünftigen Orten der Kontakte zur Silizium-Absorberschicht in der organischen Isolationsschicht mit einem gepulsten UV- Laser Markierungen aufgebracht werden ohne dabei das Material durchgängig abzutragen. Diese Markierungen werden anschließend in mindestens einem nasschemischen, selektiven und großflächigen Ätzschritt durch die Emitterschicht bis in die Silizium-Absorberschicht geöffnet. Anschließend werden Löcher für die Kontakte zur Emitterschicht in der Isolationsschicht erzeugt, indem an zukünftigen Orten der Kontakte zur Emitterschicht wiederum mit einem gepulsten UV-Laser Markierungen aufgebracht und anschließend in einem nasschemischen, selektiven und großflächigen Ätzschritt bis zur TCO-Schicht geöffnet werden. Es sei darauf hingewiesen, dass alle Ätzschritte im erfindungsgemäßen Verfahren großflächig - im Gegensatz zum Stand der Technik für die Erzeugung punktförmiger Kontakte - durchgeführt werden und damit einfacher zu handhaben sind.

Das erfindungsgemäße Verfahren, bei dem die Kontaktlöcher durch die organische Isolationsschicht jeweils zur Emitter- bzw. Absorberschicht mittels Lasermarkierung und anschließendem Ätzschritt erzeugt werden, ist im Vergleich zum Stand der Technik nach bekannten Inkjet-Druck der Kontaktlöcher zuverlässiger und genauer. Die Verwendung eines Lasers im erfindungsgemäßen Verfahren vereinfacht auch seine Nutzung in späteren, sich anschließenden Verfahrensschritten ohne Ausrichtungs-/Positionierschwierigkeiten - z.B. für das Dotieren der Punktkontakte für die Absorberschicht mittels "laser firing". Damit ist es möglich, alle Strukturierungsschritte oder lokalen Materialbearbeitungen zur Erzeugung eines Punktkontaktsystems - beginnend mit der Vereinzelung der Solarzellen - mit einem Laser durchzuführen. Deshalb ist ein gemäß dem erfindungsgemäßen Verfahren hergestelltes Kontaktssystem ein "All-by-Laser Point-Contact-Scheme" (ALPS).

Ein weiterer Vorteil des erfindungsgemäßen Verfahrens zeigt sich in seiner Anwendung auf Hetero-Dünnschicht-Solarzellen, wobei die Bandlücke der beiden den Hetero-Übergang bildenden Materialien unterschiedlich ist und der dünne amorphe Emitter einer solchen Hetero-Dünnschicht-Solarzelle wesentlich sensibler auf laserinduzierte Wärme reagiert als der Emitter einer Homo-Übergang-Solarzelle, wobei unter einem solchen Homo-Übergang ein Übergang aus einem p-leitenden und einem n-leitenden Material mit gleicher Bandlücke zu verstehen ist. Durch die geringe Laserfluenz, mit der die Kontaktlöcher im erfindungsgemäßen Verfahren gerade nicht vollständig geöffnet werden, und die Anordnung einer Ätzstoppschicht wird der Emitter vor Schädigungen geschützt.

Es ist in einer Ausführungsform vorgesehen, dass der gepulste UV-Laser zum Erzeugen der Markierungen ohne durchgängigen Materialabtrag in der Isolationsschicht für die Ausbildung der Kontaktlöcher zur Absorber- und Emitterschicht eine akkumulierte Laserfluenz von 5 J/cm² bis 50 J/cm² aufweist. Die Größe der Laserfluenz ist u.a. abhängig von der Schichtdicke, der Umgebungstemperatur, der Zusammensetzung der Schichtmaterialien sowie der Pulsdauer und der Wellenlänge des verwendeten Lasers.

Der Einsatz eines IR-Lasers oder eines Lasers im sichtbaren Wellenlängenbereich ist ebenfalls möglich, um die Markierungen für die Kontaktlöcher in die organische Isolationsschicht einzubringen.

In einer Ausführungsform der Erfindung ist vorgesehen, dass als Material für die TCO-Schicht, die als Ätzstoppschicht dient, aluminiumdotiertes ZnO oder ITO in einer Dicke von 50 nm bis 500 nm verwendet wird.

In einer anderen Ausführungsform wird als Silizium-Absorberschicht eine mittels Lasers oder mittels Elektronenstrahls rekristallisierte polykristalline Siliziumschicht in einer Dicke von 2 µm bis 40 µm verwendet. Dabei ist das Strahlprofil sowohl des Lasers als auch des Elektronenstrahls linienförmig um möglichst großflächig rekristallisieren zu können.

Die folgenden Ausführungsformen betreffen die Emitterschicht, für die eine amorphe Siliziumschicht in einer Dicke von 5 nm bis 50 nm oder eine polykristalline Siliziumschicht in einer Dicke von 0,1 µm bis 2 µm verwendet wird. Ein organisches Material für die Ausbildung der Emitterschicht kann ebenfalls verwendet werden, da - wie bereits ausgeführt - die Emitterschicht während des erfindungsgemäßen Verfahrens durch die geringe Laserfluenz, mit der die Kontaktlöcher im erfindungsgemäßen Verfahren gerade nicht vollständig geöffnet werden und durch die Anordnung einer Ätzstoppschicht vor Schädigungen geschützt wird.

Ausführungsformen für die Absorberschicht sind die folgenden:
In einer ersten Ausführungsform wird p-leitendes Silizium verwendet und als Verfahrensschritt zur selektiven Dotierung der Absorber-Kontaktlöcher ein Aluminium-Feuern mittels Lasers durchgeführt.

Eine zweite Ausführungsform hierzu sieht vor, als Material für die Absorberschicht n-leitendes Silizium zu verwenden und als Verfahrensschritt zur selektiven Dotierung der Absorber-Kontaktlöcher ein Phosphor- oder Antimon-Feuern mittels Lasers einzusetzen. Die Dotierstoffe können entweder zusammen mit dem als leitfähige Schicht verwendeten Silber abgeschieden werden oder es wird auf eine bereits abgeschiedene Silberschicht eine diese Stoffe enthaltene Schicht aufgebracht und anschließend gefeuert.

Mit dem mindestens einen nasschemischen, selektiven Ätzschritt werden erfindungsgemäß die Lasermarkierungen für die Bildung der Kontaktlöcher zur Silizium-Absorberschicht und zur Emitterschicht zunächst in der organischen Isolationsschicht geöffnet. Dabei wird eine ca. 1,5 %ige KOH-Lösung verwendet, die über eine Zeitdauer von einer bis 10 min auf die Lasermarkierungen einwirkt.
Die durch den mindestens einen nasschemischen, selektiven Ätzschritt geöffnete TCO-Schicht in den Bereichen der Lasermarkierungen wird - gemäß der Erfindung - in dem mindestens einen weiteren Ätzschritt mit einer HF-Lösung vollständig entfernt und danach die dann offenliegende Emitterschicht mittels KMnO₄ in HF-Lösung bis zur erforderlichen Tiefe geätzt. Für die auf die Emitterschicht aufgebrachte organische Isolationsschicht wird in einer weiteren Ausführungsform eine weiße Lackschicht verwendet, die gleichzeitig als Reflexionsschicht dient. Diese Lackschicht kann beispielsweise mittels Sprühbeschichtung, Tauchbeschichtung oder Siebdruckverfahren aufgebracht werden.
Zwischen der Si-Absorberschicht und der Emitterschicht wird in einer anderen Ausführungsform eine intrinsische amorphe Si-Schicht als Passivierungsschicht angeordnet.

### Ausführungsbeispiel

Die Erfindung soll in folgendem Ausführungsbeispiel anhand von Figuren näher erläutert werden.

Dazu zeigen
- Figur 1a bis 1d:: schematisch die Abfolge einzelner Verfahrensschritte des erfindungsgemäßen Verfahrens,
- Figur 2a:: eine Rasterelektronmikroskop-Aufnahme einer Lasermarkierung in der Lackschicht
- Figur 2b:: eine Rasterelektronmikroskop-Aufnahme nach dem Ätzen dieser Markierung in der Lackschicht.

Es wird von einer Schichtanordnung ausgegangen, die eine mittels PECVD-Verfahren oder Elektronstrahlverdampfung abgeschiedene und anschließend via Laser- oder Elektronenstrahl rekristallisierte, 10 µm dicke, planare, polykristalline p-Si-Absorberschicht **3** (Bandgap: 1,1 eV) auf einem Glassubstrat **1** (Dicke 3,3 mm) aufweist, die mit einer 13 nm dicken i-a-Si-Schicht passiviert ist, auf der eine 13 nm dicke, n-dotierte a-Si-Emitterschicht **4** (Bandgap der Emitterschicht: 1,8 eV) mit einer darauf aufgebrachten Al-dotierten ZnO-Schicht **5** mit einer Dicke von 300 nm angeordnet ist.

Für die nun an dieser Schichtanordnung mit einem Laser auszuführenden Verfahrensschritte wird ein gepulster Nd dotierter Vanadate-ns-Laser (λ = 532 nm) und ein Nd dotierter YAG-ps-Festkörperlaser (λ = 1064 nm, 355 nm) verwendet.

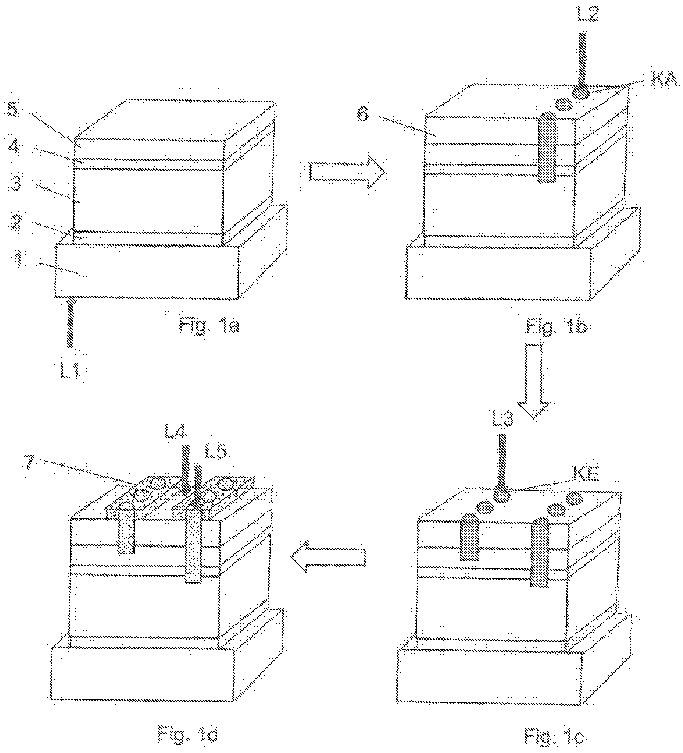

Im ersten Verfahrensschritt wird die Größe der Solarzelle definiert durch Schreiben von Isolationslinien **L1** mittels eines IR ps-Lasers (Pulsfluenz von ca. 3,9 J/cm² und Spotüberlapp von ca. 80 %) von der Substratseite her (Fig. 1a). Danach wird eine 5 µm dicke, weiße Lackschicht **6** - in diesem Beispiel Novolac 150 in einem Gemisch mit TiO₂-Nanopartikeln (Verhältnis 5 : 1) - mittels Rotationsbeschichtung auf die ZnO:Al-Schicht **5** aufgebracht und die Kontaktlöcher **KA** für die Absorberschicht **3** mittels eines UV-ps-Lasers markiert **L2.** Der Laser weist dabei eine akkumulierte Laserfluenz von ca. 20 J/cm² bei der gegebenen Dicke der Lackschicht und der verwendeten Laseranordnung auf. In einem Folgeschritt werden diese markierten Bereiche in der Lackschicht **6** nasschemisch bis zur ZnO:-Al-Schicht **5** mit z.B. einer 1,5 %igen, wässrigen KOH-Lösung geöffnet. Das weitere Ätzen der ZnO:-Al-Schicht **5** erfolgt mittels einer 5 %-igen HF-Lösung über ca. 60 s und das der Emitterschicht mit einer 1 %-igen HF-Lösung, in der 0,01 % KMnO₄ gelöst enthalten sind, über ca. 10 s (Fig. 1b). Anschließend erfolgt die Markierung der Kontaktlöcher **KE** für die Emitterschicht **4** wiederum mittels eines UV-ps-Lasers **L3** und ca. 20 J/cm² akkumulierter Laserfluenz, gefolgt von einem weiteren (KOH-) Ätzschritt - wie oben beschrieben -, der die Lackschicht bis zur ZnO:Al-Schicht **5** öffnet. In diesem Zustand wird die Schichtanordnung in eine Dampfatmosphäre eines Lösungsmittels eingebracht, wodurch der Lack der Schicht **6** weich wird und über die Kanten der Kontaktlöcher **KA, KE** in diese fließt (nicht dargestellt in der Figur). Damit ist die Emitterschicht **4** isoliert bezüglich der sie durchdringenden Kontaktlöcher **KA** für die Absorberschicht **3** (Fig. 1c). In einem anschließenden Verfahrensschritt wird eine 100 nm dicke Aluminium-Schicht **7** auf die gesamte Fläche der mit Kontaktlöchern **KA, KE** versehenen Lackschicht **6** aufgebracht. Diese wird dann mittels Laserschneidens **L4** mit einem UV-Laser auf der jeweiligen Zelle in Bereiche mit Kontaktlöchern **KE** für die Emitterschicht **4** und in Bereiche mit Kontaktlöchern **KA** für die Absorberschicht **3** separiert (Fig. 1d).Damit ist eine zellenübergreifende Serienschaltung realisierbar. Der letzte dargestellte und mit einem Laser durchgeführte Verfahrensschritt zeigt das Dotieren **L5** der Absorber-Kontaktlöcher **KA** mit Aluminium mittels eines ns-Lasers (ebenfalls Fig. 1d).

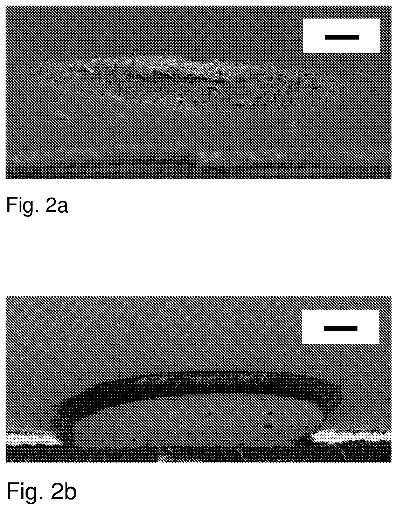

In Figur 2a - einer REM-Aufnahme - ist ein in der Lackschicht mittels ps-UV-Laser (bei einer akkumulierten Laserfluenz von ca. 20 J/cm²) erzeugter markierter Kreis zu erkennen. Zum Größenvergleich ist eine Linie von 10 µm in der gleichen Aufnahme dargestellt.
Figur 2b zeigt diesen Teil der Schicht nach dem KOH-Ätzschritt. Es ist zu erkennen, dass der markierte Bereich für das Kontaktloch entfernt wurde.

### Bezuqszeichenliste

- 1: Substrat
- 2: isolierende Schicht
- 3: Si-Absorberschicht
- 4: Emitterschicht
- 5: ZnO:Al-Schicht
- 6: Lackschicht
- 7: Al-Schicht
- KA: Absdorber-Kontaktlöcher
- KE: Emitter-Kontaktlöcher
- L1: Laserschreiben von Isolationslinien
- L2: Lasermarkieren von KA
- L3: Lasermarkieren von KE
- L4: Laserschneiden der Al-Schicht
- L5: Laserdotieren der KA

## Patentansprüche

1. Verfahren zur Herstellung eines Rückseitenkontaktsystems für eine Silizium-Dünnschicht-Solarzelle mit einem aus einer Silizium-Absorberschicht (3) und einer Emitterschicht (4) gebildeten pn-Übergang, mindestens aufweisend die Verfahrensschritte
- Aufbringen einer TCO-Schicht (5) auf die Emitterschicht (4),
- Aufbringen einer organischen Isolationsschicht (6) auf die TCO-Schicht (5),
- dann Erzeugen von Kontaktlöchern (L2, L3) in der Isolationsschicht bis zur Absorber- (KA) und Emitterschicht (KE), in dem
- Löcher für die Kontakte zur Silizium-Absorberschicht (KA) in der Isolationsschicht erzeugt werden, indem zunächst an zukünftigen Orten der Kontakte zur Silizium-Absorberschicht (KA) in der organischen Isolationsschicht (6) mit einem gepulsten UV-Laser Markierungen ohne durchgängigen Materialabtrag erzeugt werden und diese anschließend in mindestens einem nasschemischen, selektiven Ätzschritt zunächst bis zur TCO-Schicht (5), die als Ätzstoppschicht dient und dann in mindestens einem weiteren Ätzschritt durch die Emitterschicht (4) hindurch zur Silizium-Absorberschicht (3) geätzt werden,
- anschließend in der organischen Isolationsschicht (6) mit einem gepulsten UV-Laser Markierungen ohne durchgängigen Materialabtrag erzeugt und diese in einem nasschemischen selektiven Ätzschritt bis zur TCO-Schicht (5), die als Ätzstoppschicht dient geätzt werden als Kontakte bis zur Emitterschicht (KE) und
- anschließendes Isolieren der Kontaktlöcher, so dass die Emitterschicht (4) gegenüber der Absorberschicht (3) in den Kontaktlöchern (KA) isoliert ist,
- danach Aufbringen einer niedrigschmelzenden Metallschicht (7) zur Bildung von n- und p-Kontakten in den Kontaktlöchern (KA, KE),
- Separierung der Metallschicht (7) in n- und p-kontaktierende Bereiche mittels Laserschneidens (L4) und
- danach die erzeugten Löcher für die Kontakte zur Si-Absorberschicht (KA) selektiv dotiert werden (L5).

2. Verfahren zur Herstellung eines Rückseitenkontaktsystems für eine Dünnschicht-Solarzelle gemäß Anspruch 1,
**dadurch gekennzeichnet, dass**
der gepulste UV-Laser zum Erzeugen der Markierungen ohne durchgängigen Materialabtrag in der Isolationsschicht (6) für die Ausbildung der Kontaktlöcher zur Absorber- und Emitterschicht (KA, KE) eine Laserfluenz von 5 J/cm² bis 50 J/cm² aufweist.

3. Verfahren zur Herstellung eines Rückseitenkontaktsystems für eine Dünnschicht-Solarzelle gemäß Anspruch 1,
**dadurch gekennzeichnet, dass**
als Material für die TCO-Schicht (5), die als Ätzstoppschicht dient, aluminiumdotiertes ZnO oder ITO in einer Dicke von 50 nm bis 500 nm verwendet wird.

4. Verfahren zur Herstellung eines Rückseitenkontaktsystems für eine Dünnschicht-Solarzelle gemäß Anspruch 1,
**dadurch gekennzeichnet, dass**
als Silizium-Absorberschicht (3) eine mittels Lasers oder mittels Elektronenstrahls rekristallisierte polykristalline Siliziumschicht in einer Dicke von 2 µm bis 40 µm verwendet wird.

5. Verfahren zur Herstellung eines Rückseitenkontaktsystems für eine Dünnschicht-Solarzelle gemäß Anspruch 1,
**dadurch gekennzeichnet, dass**
als Emitterschicht (4) eine amorphe Siliziumschicht in einer Dicke von 5 nm bis 50 nm verwendet wird.

6. Verfahren zur Herstellung eines Rückseitenkontaktsystems für eine Dünnschicht-Solarzelle gemäß Anspruch 1,
**dadurch gekennzeichnet, dass**
als Emitterschicht (4) eine polykristalline Siliziumschicht mit eine Dicke von 0,1 µm bis 2 µm verwendet wird.

7. Verfahren zur Herstellung eines Rückseitenkontaktsystems für eine Dünnschicht-Solarzelle nach mindestens einem der vorangehenden Ansprüche,
**dadurch gekennzeichnet, dass**
als Material für die Absorberschicht (3) p-leitendes Silizium verwendet wird und als Verfahrensschritt zur selektiven Dotierung der Absorber-Kontaktlöcher (L5) ein Aluminium-Feuern mittels Lasers durchgeführt wird.

8. Verfahren zur Herstellung eines Rückseitenkontaktsystems für eine Dünnschicht-Solarzelle nach mindestens einem der vorangehenden Ansprüche 1 bis 6,
**dadurch gekennzeichnet, dass**
als Material für die Absorberschicht (3) n-leitendes Silizium verwendet wird und als Verfahrensschritt zur selektiven Dotierung der Absorber-Kontaktlöcher (L5) ein Phosphor- oder Antimon-Feuern mittels Lasers durchgeführt wird.

9. Verfahren zur Herstellung eines Rückseitenkontaktsystems für eine Dünnschicht-Solarzelle gemäß Anspruch 1,
**dadurch gekennzeichnet, dass**
in dem mindestens einen nasschemischen, selektiven Ätzschritt die Lasermarkierungen für die Ausbildung der Kontaktlöcher zur Silizium-Absorberschicht (KA) und zur Emitterschicht (KE) in einer ca. 1,5 %igen KOH-Lösung über eine Zeitdauer von einer bis 10 min geätzt werden.

10. Verfahren zur Herstellung eines Rückseitenkontaktsystems für eine Dünnschicht-Solarzelle gemäß Anspruch 1,
**dadurch gekennzeichnet, dass**
die durch den mindestens einen nasschemischen, selektiven Ätzschritt geöffnete TCO-Schicht (5) in den Bereichen der Lasermarkierungen in dem mindestens einen weiteren Ätzschritt mit einer HF-Lösung vollständig entfernt wird und danach die dann offenliegende Emitterschicht (4) mittels KMnO₄ in HF-Lösung bis zur erforderliche Tiefe entfernt wird.

11. Verfahren zur Herstellung eines Rückseitenkontaktsystems für eine Dünnschicht-Solarzelle gemäß Anspruch 1,
**dadurch gekennzeichnet, dass**
für die auf die Emitterschicht (4) aufgebrachte organische Isolationsschicht (6) eine weiße Lackschicht verwendet wird, die gleichzeitig als Reflexionsschicht dient.

12. Verfahren zur Herstellung eines Rückseitenkontaktsystems für eine Dünnschicht-Solarzelle gemäß Anspruch 1,
**dadurch gekennzeichnet, dass**
zwischen der Si-Absorberschicht (3) und der Emitterschicht (4) eine intrinsische amorphe Si-Passivierungsschicht angeordnet wird.

## Claims

1. Method to produce a back-side contact system for a silicon thin-film solar cell with a pn-transition made of a silicon absorber layer (3) and an emitter layer (4), comprising at least the process steps:
- applying a TCO layer (5) onto the emitter layer (4),
- applying an organic insulation layer (6) to the TCO layer (5),
- then, generating contact holes (L2, L3) in the insulation layer up to the absorber (KA) and emitter layer (KE), in which
- holes for the contacts to the silicon absorption layer (KA) are generated in the insulation layer by initially generating them on future locations of the contacts to the silicon absorption layer (KA) in the organic insulation layer (6) by means of pulsed UV laser marking without continuous material removal and these are then etched at at least a selective wet-chemical etching step initially up to the TCO layer (5), which serves as an etching stop layer, and then, at at least another etching step, they are etched to penetrate through the emitter layer (4) to the silicone absorber layer (3),
- then, they are generated in the organic insulation layer (6) by means of intermittent UV laser marking without continuous material removal and these are then etched in at least a selective wet-chemical etching step initially up to the TCO layer (5), which serves as an etching stop layer as contacts to the emitter layer (KE) and
- subsequent isolation of the contact holes takes place so that the emitter layer (4) is insulated against the absorber layer (3) in the contact holes (KA),
- after, attaching a low-melting metal layer (7) to form n- and p-contacts in the contact holes (KA, KE),
- separation of the metal layer (7) in to areas contacting n and p by means of laser cutting (L4) and
- afterwards, the created holes for the contacts to the Si-absorber layer (KA) are selectively doped (L5) .

2. Method to produce a back-side contact system for a thin-film solar cell according to claim 1, **characterized in that** the pulsed UV laser to generate the markings without continuous material removal in the insulation layer (6) for forming contact holes to the absorber and emitter layer (KA, KE) have a laser fluence of 5 J/cm² to 50 J/cm².

3. Method to produce a back-side contact system for a thin-film solar cell according to claim 1, **characterized in that** aluminium-doped ZnO or ITO at a thickness of 50 nm to 500 nm is used as the material for the TCO layer (5), which serves as an etching stop layer.

4. Method to produce a back-side contact system for a thin-film solar cell according to claim 1, **characterized in that** a polycrystalline silicon layer recrystalized by means of an electron beam or by means of a laser at a thickness of 2 µm to 40 µm is used as a silicon absorber layer (3).

5. Method to produce a back-side contact system for a thin-film solar cell according to claim 1, **characterized in that** an amorphous silicon layer at a thickness of 5 nm to 50 nm is used as an emitter layer (4) .

6. Method to produce a back-side contact system for a thin-film solar cell according to claim 1, **characterized in that** a polycrystalline silicon with a thickness of 0.1 µm to 2 µm is used as an emitter layer (4).

7. Method to produce a back-side contact system for a thin-film solar cell according to at least one of the preceding claims, **characterized in that** p-conductive silicon is used as a material for the absorber layer (3) and aluminium firing by means of a layer is carried out as a process step for the selective doping of the absorber contact holes (L5).

8. Method to produce a back-side contact system for a thin-film solar cell according to at least one of the preceding claims 1 to 6, **characterized in that** n-conductive silicon is used as a material for the absorber layer (3) and phosphor or antimony firing by means of a layer is carried out as a process step for the selective doping of the absorber contact holes (L5) .

9. Method to produce a back-side contact system for a thin-film solar cell according to claim 1, **characterized in that** in an at least one wet-chemical selective etching step, the laser markings for forming the contact holes for the silicon absorber layer (KA) and for the emitter layer (KE) are etched in a KOH solution with an approx. 1.5% dil. over a time period of at least one to 10 min.

10. Method to produce a back-side contact system for a thin-film solar cell according to claim 1, **characterized in that** the TCO layer (5) opened by the at least one wet-chemical selective etching step in the area of the laser markings at the at least one other etching step with an HF solution is fully removed and afterwards, the open emitter layer (4) is removed by mean of KMnO₄ in an HF solution until the required depth is achieved.

11. Method to produce a back-side contact system for a thin-film solar cell according to claim 1, **characterized in that** for the organic insulation layer (6) applied to the emitter layer (4), a white paint coating is used, which simultaneously serves as a reflective layer.

12. Method to produce a back-side contact system for a thin-film solar cell according to claim 1, **characterized in that** an intrinsic amorphous Si-passivation layer is arranged between the Si absorber layer (3) and the emitter layer (4).

## Revendications

1. Procédé, destiné à produire un système à contact arrière pour une cellule solaire en silicium en couches minces, présentant une transition p-n, créée avec une couche absorbante en silicium (3) et une couche émettrice (4), comportant au moins les étapes de procédé consistant à :
- appliquer une couche de TCO (5) sur la couche émettrice (4),
- appliquer une couche isolante organique (6) sur la couche de TCO (5),
- puis créer des trous de contact (L2, L3) dans la couche isolante jusqu'à la couche absorbante (KA) et la couche émettrice (KE), en
- créant dans la couche isolante des trous pour les contacts vers la couche absorbante en silicium (KA,) en créant dans un premier temps aux endroits futurs des contacts vers la couche absorbante en silicium (KA) des marquages sans enlèvement de matière constant dans la couche isolante organique (6) à l'aide d'un laser UV pulsé, en gravant ensuite ces derniers dans au moins une étape de gravure chimique humide sélective, d'abord jusqu'à la couche de TCO (5), qui fait office de couche d'arrêt de la gravure et ensuite, dans au moins une étape de gravure supplémentaire à travers la couche émettrice (4) vers la couche absorbante en silicium (3),
- en créant ensuite dans la couche isolante organique (6), à l'aide d'un laser UV pulsé des marquages sans enlèvement de matière constant et en gravant ces derniers dans une étape de gravure chimique humide sélective, d'abord jusqu'à la couche de TCO (5), qui fait office de couche d'arrêt de la gravure en tant que contacts jusqu'à la couche émettrice (KE) et
- en isolant ensuite les trous de contact, de sorte que la couche émettrice (4) soit isolée par rapport à la couche absorbante (3) dans les trous de contact (KA),
- en appliquant ensuite une couche métallique (7) fusible à basse température pour créer des contact n et p dans les trous de contact (KA, KE),
- en séparant la couche métallique (7) dans des zones de mise en contact n- et p par découpe au laser (L4) et
- en dopant ensuite sélectivement (L5) les trous créés pour les contacts vers la couche Si absorbante (KA).

2. Procédé, destiné à produire un système à contact arrière pour une cellule solaire en silicium en couches minces selon la revendication 1, **caractérisé en ce que** pour la création des trous de contact vers la couche absorbante et la couche émettrice (KA, KE), le laser UV pulsé destiné à créer les marquages sans enlèvement de matière constant dans la couche isolante (6), présente une fluence laser de 5 J/cm² à 50 J/cm².

3. Procédé, destiné à produire un système à contact arrière pour une cellule solaire en silicium en couches minces selon la revendication 1, **caractérisé en ce qu'**en tant que matière pour la couche de TCO (5), qui fait office de couche d'arrêt de la gravure, on utilise du ZnO ou ITO dopé à l'aluminium, dans une épaisseur de 50 nm à 500 nm.

4. Procédé, destiné à produire un système à contact arrière pour une cellule solaire en silicium en couches minces selon la revendication 1, **caractérisé en ce qu'**en tant que couche absorbante en silicium (3), on utilise une couche de silicium polycristallin recristallisée au laser ou au faisceau d'électrons dans une épaisseur de 2 µm à 40 µm.

5. Procédé, destiné à produire un système à contact arrière pour une cellule solaire en silicium en couches minces selon la revendication 1, **caractérisé en ce qu'**en tant que couche émettrice (4), on utilise une couche de silicium amorphe dans une épaisseur de 5 nm à 50 nm.

6. Procédé, destiné à produire un système à contact arrière pour une cellule solaire en silicium en couches minces selon la revendication 1, **caractérisé en ce qu'**en tant que couche émettrice (4), on utilise une couche de silicium polycristallin d'une épaisseur de 0,1 µm à 2 µm.

7. Procédé, destiné à produire un système à contact arrière pour une cellule solaire en silicium en couches minces selon au moins l'une quelconque des revendications précédentes, **caractérisé en ce qu'**en tant que matière pour la couche absorbante (3), on utilise du silicium p-conducteur et en tant qu'étape de procédé pour le dopage sélectif des trous de contact (L5) dans la couche absorbante, on procède à une trempe d'aluminium au laser.

8. Procédé, destiné à produire un système à contact arrière pour une cellule solaire en silicium en couches minces selon au moins l'une quelconque des revendications précédentes 1 à 6, **caractérisé en ce qu'**en tant que matière pour la couche absorbante (3), on utilise du silicium n-conducteur et en tant qu'étape de procédé pour le dopage sélectif des trous de contact (L5) dans la couche absorbante, on procède à une trempe de phosphore ou d'antimoine au laser.

9. Procédé, destiné à produire un système à contact arrière pour une cellule solaire en silicium en couches minces selon la revendication 1, **caractérisé en ce que** dans l'au moins une étape chimique humide de gravure sélective, on grave les marquages au laser pour la création des trous de contact vers la couche absorbante de silicium (KA) et vers la couche émettrice (KE) dans une solution KOH à env. 1,5 % sur une durée d'une à 10 mn.

10. Procédé, destiné à produire un système à contact arrière pour une cellule solaire en silicium en couches minces selon la revendication 1, **caractérisé en ce qu'**on enlève complètement la couche de TCO (5) ouverte par l'au moins une étape chimique humide de gravure sélective dans les zones de marquage laser dans l'au moins une étape de gravure additionnelle à l'aide d'une solution HF et on retire ensuite la couche émettrice (4) ouverte jusqu'à la profondeur requise à l'aide de KMnO₄ dans une solution HF-.

11. Procédé, destiné à produire un système à contact arrière pour une cellule solaire en silicium en couches minces selon la revendication 1, **caractérisé en ce qu'**on utilise pour la couche organique isolante (6) appliquée sur la couche émettrice (4) une couche de peinture blanche qui fait simultanément office de couche de réflexion.

12. Procédé, destiné à produire un système à contact arrière pour une cellule solaire en silicium en couches minces selon la revendication 1, **caractérisé en ce qu'**entre la couche absorbante Si (3) et la couche émettrice (4), on place une couche de passivation Si intrinsèquement amorphe.
